# FASCICULE DE BREVET EUROPEEN

(11) **EP 2 162 908 B1**
(45) Date de publication et mention de la délivrance du brevet: **07.09.2022**
(21) Numéro de dépôt: 08760581.2
(22) Date de dépôt: 05.06.2008
(51) Int. Cl.: H01L 21/98, H01L 25/065, H01L 21/56, H01L 23/31, H01L 23/538, H01L 25/10, B81C 1/00

(54) **PROCÉDÉ DE RÉALISATION D'UN DISPOSITIF ÉLECTRONIQUE RECONSTITUÉ ET DISPOSITIF ÉLECTRONIQUE RECONSTITUÉ CORRESPONDANT**
HERSTELLUNGSVERFAHREN EINES REKONSTITUIERTEN ELEKTRONISCHEN BAUELEMENTS UND ENTSPRECHENDES REKONSTITUIERTES ELEKTRONISCHES BAUELEMENT
RECONSTITUTED ELECTRONIC DEVICE FABRICATION PROCESS AND CORRESPONDING RECONSTITUTED ELECTRONIC DEVICE

(30) Priorité: 07.06.2007 FR 0755578
(43) Date de publication de la demande: 17.03.2010
(73) Titulaire: Commissariat à l'Énergie Atomique et aux Énergies Alternatives, 75015 Paris (FR)
(72) Inventeur: BALERAS, François, F-38450 Saint Georges de Commiers (FR); SOURIAU, Jean-Charles, F-38120 Saint-Égrève (FR); POUPON, Gilles, F-38170 Seyssinet Pariset (FR); VERRUN, Sophie, F-38100 Grenoble (FR)
(74) Mandataire: Ilgart, Jean-Christophe
(86) Numéro de dépôt international: PCT/EP2008/057005
(87) Numéro de publication internationale: WO 2008/148847

(56) Documents cités:
- WO-A1-2006/032250
- DE-A1- 19 920 444
- DE-A1-102004 027 788
- DE-A1-102005 030 465
- DE-A1-102005 043 557
- US-A- 4 525 921
- US-A- 5 025 306
- US-A- 5 904 502
- US-A- 5 963 793
- US-A1- 2002 042 163
- US-A1- 2005 023 656
- CAHILL C ET AL: "THERMAL CHARACTERIZATION OF VERTICAL MULTICHIP MODULES MCM-V" IEEE TRANSACTIONS ON COMPONENTS, PACKAGING AND MANUFACTURING TECHNOLOGY: PART A, IEEE SERVICE CENTER, PISCATAWAY, NJ, US, vol. 18, no. 4, 1 décembre 1995 (1995-12-01), pages 765-771, XP000542882 ISSN: 1070-9886 cité dans la demande

## Description

### DOMAINE TECHNIQUE ET ART ANTERIEUR

L'invention concerne le domaine de l'intégration de composants électroniques dans un dispositif électronique reconstitué (également appelé substrat par la suite).

Elle permet de réaliser des substrats reconstitués qui contiennent des composants dont les connexions débouchent sur une surface du substrat. De tels substrats reconstitués ont une forte densité de composants. Ils peuvent eux-mêmes éventuellement être empilés, ce qui contribue encore à une augmentation sensible de la densité de composants.

L'augmentation de la densité d'intégration des composants ainsi que la recherche de l'amélioration des performances et la diminution des coûts des dispositifs amènent les fournisseurs de systèmes à développer des dispositifs de plus en plus compacts.

On voit se développer des nouvelles techniques d'intégration, qui permettent d'augmenter la compacité des puces, ou des systèmes de puces, tout en en réduisant le coût et en en conservant la fiabilité.

Le document EP 0695494 décrit un module comprenant une série de circuits intégrés, par exemple des puces mémoires. Ces puces mémoires sont montées sur une puce active comprenant les interconnexions pour les différentes puces. La puce active comporte des bossages en alliage fusible pour assembler et connecter les puces mémoires. Toutes les connexions des puces sont transférées vers le bord de la plus active pour pouvoir les connecter sur les flancs du boîtier. Il en résulte un montage compliqué, et pour lequel la densité de composants n'est pas optimisée.

Le document US 5 688 721 décrit le reroutage de puces pour transférer les connexions de ces puces sur les bords d'un bloc de puces assemblées. Plus précisément, des pistes sont connectées à des plots par des vias métallisés, à travers une première couche isolante. Les pistes sont recouvertes d'une deuxième couche isolante, puis une couche adhésive est ajoutée pour empiler les substrats. Une structure décrite dans ce document présente des découpes et des reprises des contacts sur une face latérale, perpendiculaire à un empilement de puces. Les contacts sur la face latérale sont obtenus par métallisation d'une couche isolante latérale. Les différents étages empilés sont connectés par des métallisations sur ladite face latérale.

Cette technique présente plusieurs inconvénients.

Tout d'abord, un premier problème concerne la surface du silicium, qui se retrouve à nu (après la découpe) sur la surface à traiter ; il faut donc déposer une couche de passivation sur cette surface.

Une deuxième difficulté concerne la découpe de matériaux de duretés différentes (il y a en particulier, dans l'empilement, des matériaux souples comme le polyimide). En outre, le fait de découper du métal provoque des bavures et une contamination du silicium.

Un autre problème est celui du montage de composants de dimensions différentes, que cette technique ne permet pas de réaliser.

Dans le document DE 10 2005 30465, des dispositifs semi-conducteurs sont assemblés. Chacun de ces dispositifs comprend respectivement une puce encapsulée dans un matériau plastique. Ces différents dispositifs sont ensuite empilés puis enrobés par un matériau. Dans ce document, les connexions sont donc disposées sur la couche d'encapsulation de la puce.

De même, dans l'article de Cahill et al.,intitulé « THERMAL CHARACTERIZATION OF VERTICAL MULTICHIP MODULES MCM-V », IEEE Transactions on Components, Packaging and Manufacturing Technology : Part A, IEEE Service Center, vol. 18, no. 4, 1 décembre 1995, pages 765-771, des puces nues (c'est-à-dire non encapsulées) ne sont pas intégrés directement dans un dispositif. En effet, chaque puce est d'abord disposée sur un substrat auquel elle est connectée par des liaisons externes (« wire bonding ») puis l'ensemble ainsi obtenu est ensuite reporté sur un support.

Il se pose donc le problème de trouver de nouveaux procédés pour réaliser de manière plus simple des substrats reconstitués et des empilements, ou des intégrations 3D, notamment comportant des vias et au moins un composant.

Le documents DE 10 2005 043557 A1 divulgue un composant semi-conducteur avec contact traversant entre ses deux surfaces et son procédé de réalisation.

Le document DE 10 2004 027 788 A1 divulgue composant semi-conducteur comportant un substrat de recâblage et une plaque de distribution.

### EXPOSÉ DE L'INVENTION

L'invention concerne d'abord un procédé de réalisation d'un dispositif électronique reconstitué selon la revendication 1.

L'invention concerne également un dispositif électronique reconstitué selon la revendication 7.

Des mises en œuvre privilégiées de l'invention sont de plus présentées dans les revendications dépendantes.

En particulier, des pistes de connexion peuvent être réalisées sur la première et/ou la deuxième face du dispositif électronique reconstitué. On peut alors réaliser une interconnexion après la reconstitution d'un substrat, afin de réaliser collectivement la connexion d'un ensemble de systèmes.

### BRÈVE DESCRIPTION DES DESSINS

- Les figures 1A à 1C sont des exemples de composants, en eux-mêmes non couverts par les revendications, pouvant être utilisés en vue de la réalisation d'un substrat reconstitué.
- Les figures 1D et 1E sont des exemples de substrats reconstitués, non couverts par les revendications.
- Les figures 2A-2C sont d'autres exemples de substrats reconstitués non couverts par les revendications.
- La figure 3A illustre la préparation de vias destinés à être incorporé dans un dispositif électronique reconstitué selon l'invention.
- La figure 3B représente un dispositif électronique reconstitué selon l'invention, munis de vias verticaux.
- Les figures 4A-4E sont des étapes d'un procédé selon l'invention.
- La figure 5 représente des vias avec extrémité conique ou en forme de pointe.
- Les figures 6A-6G sont des étapes d'un exemple de fabrication de vias sur des puces.
- Les figures 7A-7C représentent divers composants, en eux-mêmes non couverts par les revendications, avec leurs éléments de connexion en vue d'une intégration dans un substrat reconstitué.
- Les figures 8A-9C sont des étapes de préparation d'un assemblage de composants destiné à être incorporé verticalement dans un substrat reconstitué.
- La figure 10 représente un empilement de composants formant un ensemble destiné à être incorporé verticalement dans un substrat reconstitué.
- La figure 11 représente un substrat reconstitué, non couvert par les revendications.
- Les figures 12A-12B représentent la préparation d'un composant, en lui-même non couvert par les revendications, en vue de son intégration dans un substrat reconstitué, par un procédé.
- Les figures 13A-13B, non couvertes par les revendications, représentent l'intégration de composants du type de ceux des figures 12A et 12B.
- Les figures 14A-14F représentent des étapes de préparation de composants, les figures 14G- 14I étant des étapes de mise en oeuvre d'un procédé non couvert par les revendications.
- les figures 15A-15F représentent des étapes de mise en oeuvre d'un autre procédé de réalisation de composants, en eux-mêmes non couverts par les revendications.
- La figure 16 représente un substrat à partir duquel un dispositif qui ne fait pas partie de l'invention peut être réalisé.
- Les figures 17A et 17B représentent la réalisation de composants avec accès physiques vers l'extérieur.

### EXPOSÉ DÉTAILLÉ DE MODES DE RÉALISATION PARTICULIERS

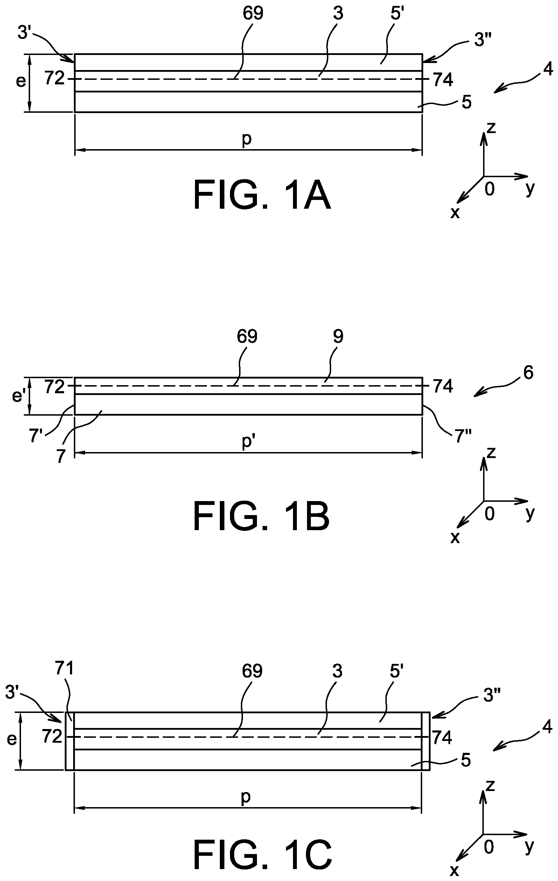

Les figures 1A à 1C représentent deux puces 4, 6, comportant chacune un ou des composants électroniques 3, 9 et un substrat support individuel 5, 7, et pouvant être utilisées dans un substrat reconstitué non couvert par les revendications. Les figures 1A à 1C permettent cependant de bien comprendre la structure des composants utilisés dans le cadre de l'invention revendiquée. Les références 3', 3", 7', 7" désignent un premier côté et un deuxième côté, ou une première portion latérale et une deuxième portion latérale, de ces puces.

Dans la suite on utilisera parfois, pour simplifier, également le terme de « composant » pour chacune de ces puces 4, 6.

Dans le cas de la puce 4 de la figure 1A, la partie 3, formant le composant ou la pluralité de composants, est encapsulée entre un substrat 5, sur lequel elle est formée et un substrat ou un capot 5'.

Dans le cas de l'ensemble 6 de la figure 1B, la partie 9, formant le composant ou la pluralité de composants, repose simplement sur un substrat 7.

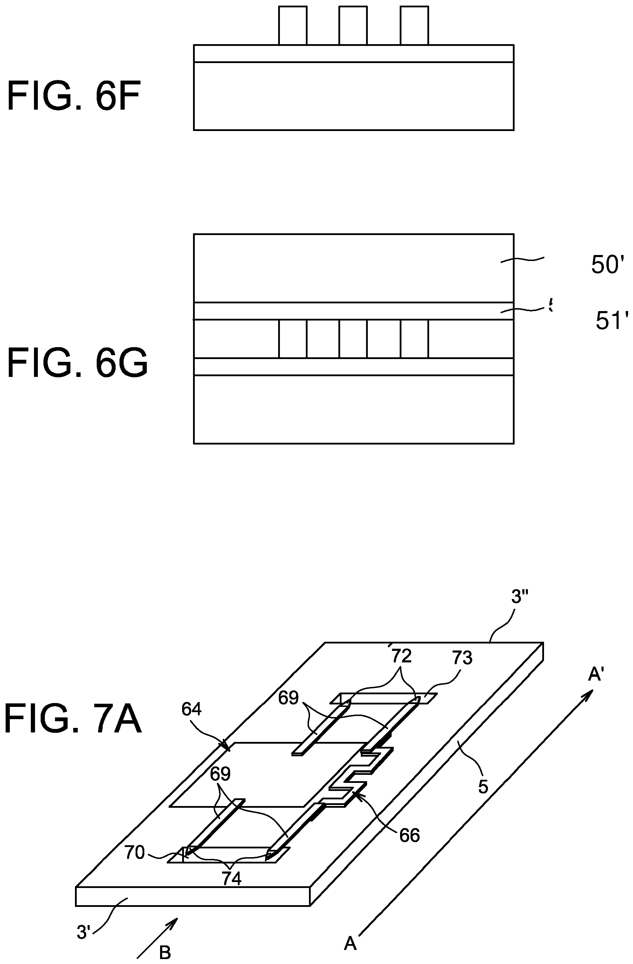

Chacune des puces 4, 6 peut avoir par exemple une épaisseur e comprise par exemple entre 300 µm et 2 mm. Chaque substrat support a de préférence une forme sensiblement rectangulaire ou carrée, comme on peut le voir sur les exemples des figures 7A-7C, qui convient à la formation d'un substrat reconstitué. Sur les figures 1A-1C, mais également 7A-7C, les côtés 3', 3", 7', 7" forment les petits côtés d'un rectangle.

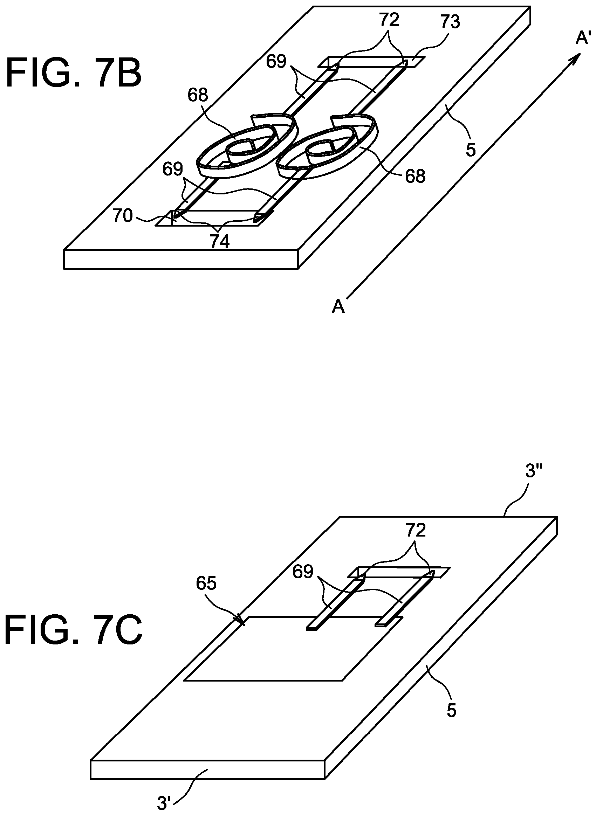

Deux contacts latéraux 72, 74, ou plots de contact, sont également visibles sur chacune de ces figures : ces contacts dépassent des portions latérales, ou affleurent ces portions latérales, de part et d'autre du composant ou de la puce. Le nombre de contacts n'est pas limité à deux, mais peut être quelconque, certains composants ne nécessitant qu'un contact, d'autres un nombre plus important (par exemple 4 pour les composants des figures 7A et 7B). Les contacts peuvent être disposés, suivant les besoins, des deux côtés 3', 3", 7', 7" du composant ou sur un seul côté de ce composant, comme dans le cas, par exemple, du composant de la figure 7C. La référence 69 désigne un éventuel préroutage interne du composant, dont les contacts 72, 74 constituent des terminaux.

Eventuellement, comme le montre la figure 1C, les extrémités latérales d'un composant sont encapsulées ou recouvertes par un matériau d'enrobage 71 tel qu'une résine. Malgré ce matériau, le ou les contacts 72, 74 restent accessibles de l'extérieur du composant. Pour le reste, ce composant de la figure 1C reste similaire à celui de la figure 1A.

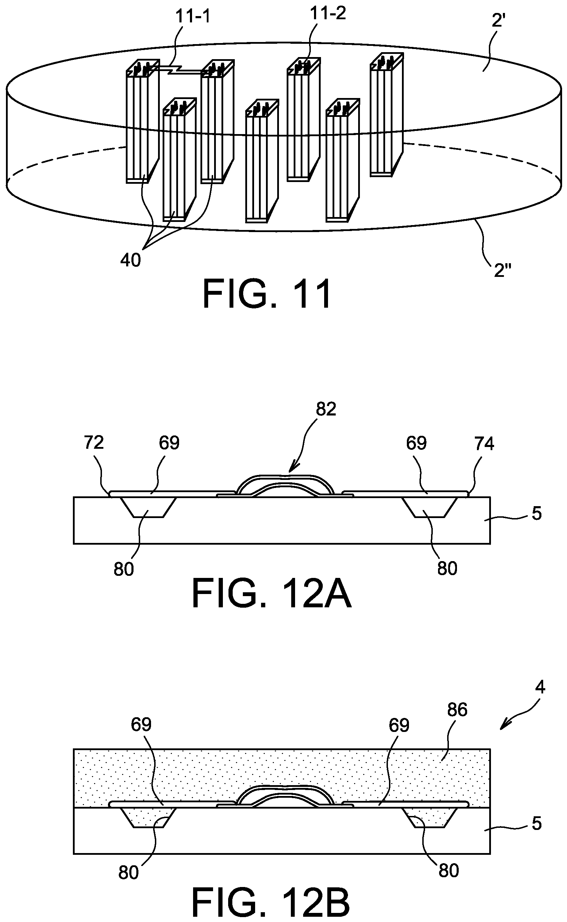

Les représentations des figures 1A à 1C sont très schématiques : tant le composant 3, 9 lui-même que ses moyens 69 de préroutage interne et ses moyens de connexion 72, 74 sont formés sur le substrat support 5, 7 individuel, comme le montreront plus en détail les exemples de structures des figures 7A-7C, 12A, 12B 14A, et 15A. Cette structure confère à chaque ensemble 4, 6 une compacité qui permet de réunir de nombreux composants individuels sous la forme d'un substrat reconstitué et évite d'avoir à recourir, comme dans le document US 5 688 721, à des couches isolantes que doivent traverser des vias métallisés.

Dans les 3 exemples présentés ci-dessus, la profondeur p, p' du composant (par exemple de l'ordre de 1 mm à 1 cm), mesurée perpendiculairement à la direction OZ de l'empilement substrat (5, 7) - composant (3, 9) - éventuellement substrat 5', est beaucoup plus grande que son épaisseur e, mesurée dans le sens de l'empilement. On peut donc parler d'un plan du composant, défini par le plan d'un des substrats 5, 5', 7 et parallèle au plan XOY.

À titre d'exemple de puces 4, 6, on peut avoir un MEMS, ou une résistance, ou une capacité ou une inductance, ou un filtre. Des exemples plus détaillés de composants seront donnés dans la suite de cette description.

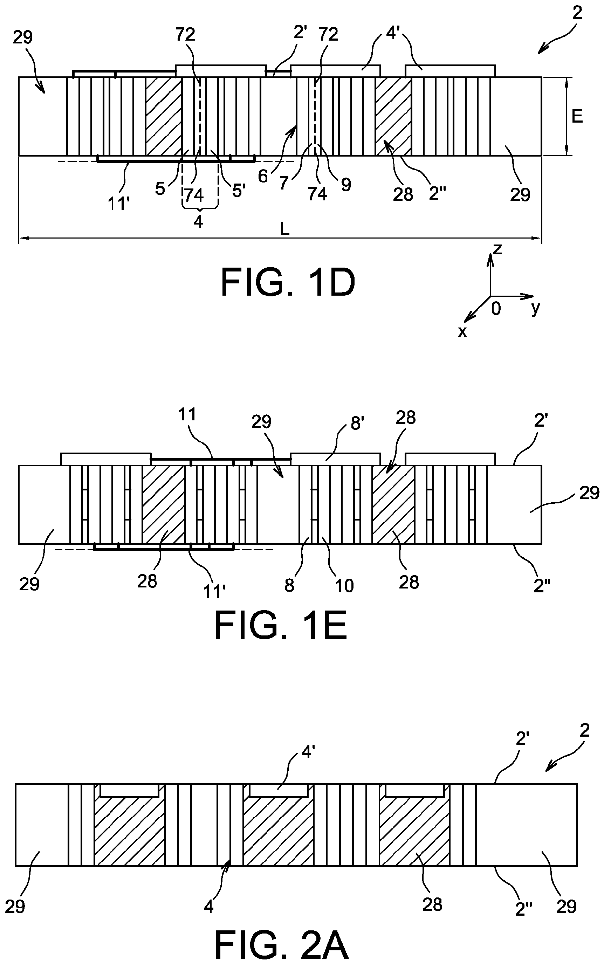

Les figures 1D et 1E illustrent des exemples de structure 3D reconstituées à l'aide de composants tels que ceux décrits ci-dessus. Ces exemples de structure 3D sont non couverts par les revendications. Dans ces exemples, ainsi que pour le reste de la description, cette structure comporte essentiellement un substrat 2, dit substrat reconstitué, d'épaisseur E par exemple comprise entre 50 µm et quelques centaines de µm, par exemple 500 µm ou même 1 mm. Ce substrat présente une largeur L, par exemple comprise entre quelques centimètres, par exemple 2 cm ou 5cm, et 20 cm ou même 30 cm (il peut même y avoir des panneaux de taille supérieure), très supérieure à cette épaisseur, et donc définit un plan xOy dit aussi « plan du substrat reconstitué ». On peut le désigner arbitrairement comme « plan horizontal », une direction Oz, sensiblement perpendiculaire à ce plan, étant désignée comme « verticale ».

L'exemple de la figure 1D représente le montage vertical, perpendiculaire au plan xOy, de puces 4, 6 du type de celles décrites ci-dessus en liaison avec les figures 1A à 1C ; par exemple le composant 4 est un microprocesseur et le composant 6 est un composant passif. Chacun de ces composants est monté verticalement : il est muni du substrat 5, 5', 7 sur lequel il a été préalablement réalisé ou monté. On a représenté schématiquement sur la figure 1D le composant 4 (de la figure 1A) avec ses substrats 5, 5' et le composant 6 (de la figure 1B) avec son substrat 7. De la même manière, dans la suite de la présente description, au moins une partie des composants montés verticalement dans un substrat reconstitué 2 le sont avec le substrat sur lequel ils ont été préalablement réalisés ou montés, sans que ce dernier ne soit explicitement représenté sur chacune des figures. Seuls deux composants 4, 6 sont identifiés et représentés de manière détaillée sur la figure 1D, mais un substrat reconstitué 2 peut comporter un grand nombre de composants de ce type. Le substrat reconstitué peut donc comporter un réseau de composants. À titre d'exemple, on peut avoir un réseau de composants ou de puces passives 6 montées verticalement, par exemple un réseau de résistance, et/ou de capacités et/ou d'inductances, et/ou de un ou plusieurs filtres ....

Dans la présente demande, chaque substrat individuel et son composant (partie électronique et/ou mécanique de la puce) avec ses pistes et ses moyens de connexion forment une puce « nue » (c'est-à-dire non encapsulée) et c'est cette puce qui est reportée sur la surface de référence avant enrobage. Les pistes et les moyens de connexion sont intégrés dans la puce, seules les extrémités ou bornes de ces moyens de connexion affleurent.

Pour chacun de ces composants, le plan du substrat 5, 7 sur, ou dans, lequel il est monté est dirigé perpendiculairement au plan xOy défini par le substrat reconstitué. En d'autres termes, on assemble les composants de manière à ce que la direction de l'empilement élémentaire que chacun constitue (identifié par la direction OZ sur la figure 1A-1C) soit orientée non pas suivant la direction Oz mais dans le plan xOy ou dans un plan parallèle. Cette direction d'assemblage est telle que le ou les moyens de connexion ou plots de contact 72, 74 de chaque composant apparaisse dans une des deux surfaces 2', 2" du substrat reconstitué. Ces deux surfaces sont définies par les portions latérales 3', 3", 7', 7" des composants élémentaires (voir figures 1A, 1B). Arbitrairement, la surface 2' est dite face avant du substrat 2, et la surface 2" est dite face arrière.

L'exemple de la figure 1E, non couvert par les revendications, représente le montage vertical de MEMS 8, 10, eux aussi introduits dans le substrat 2 avec leur propre substrat. Des exemples de structures de MEMS sont données plus loin en liaison avec les figures 12A et 12B. Un ou plusieurs des MEMS peut être de type comportant une ou des cavités sous vide ou sous gaz neutre ou encore à pression contrôlée.

Sur les figures 1D et 1E, la référence 29 désigne un cadre d'assemblage, qui permet de délimiter des zones dans chacune desquelles un ou plusieurs des composants 4, 6, 8, 10 sont disposés. Enfin, un matériau d'enrobage 28 permet de combler des espaces entre les composants, ou entre les composants et le cadre. Il peut également jouer un rôle de maintien des composants et de l'ensemble du substrat reconstitué.

Dans ces deux exemples, des composants supplémentaires 4', 8' sont montés sur l'une et/ou l'autre des surfaces 2', 2" du substrat 2, par des procédés standard d'assemblage et de connexions (par exemple par flip-chip, ou wire-bonding, ou ACF). Parmi ces composants de surface, on peut avoir notamment un ou plusieurs microprocesseurs et/ou plusieurs MEMS.

Ces composants montés en surface peuvent être en contact direct avec des connexions 72, 74 des composants 4, 6 8, 10 montés verticalement, ou par l'intermédiaire d'un circuit, ou reroutage, 11, 11' réalisé en face avant 2' ou face arrière 2". Ces circuits ou reroutages 11, 11' peuvent permettre également, ou alternativement, de connecter entre eux des composants 4, 6, ou 8, 10 montés verticalement. Ces reroutages 11, 11' de surface sont représentés comme de simples lignes de connexion sur les figures, mais chacun d'entre eux peut comporter en fait un système complexe de pistes et de connexions, perpendiculairement au plan de la figure. Pour réaliser ces reroutages de surface on peut employer des méthodes standards de microélectronique (par exemple pulvérisation cathodique d'un fond continu, lithographie et électrolyse de cuivre, stripping et gravure du fond continu).

Dans tous les exemples de substrats reconstitués donnés dans la suite de cette description, de tels reroutages de surface peuvent être prévus, mais ne sont pas explicitement représentés sur les figures.

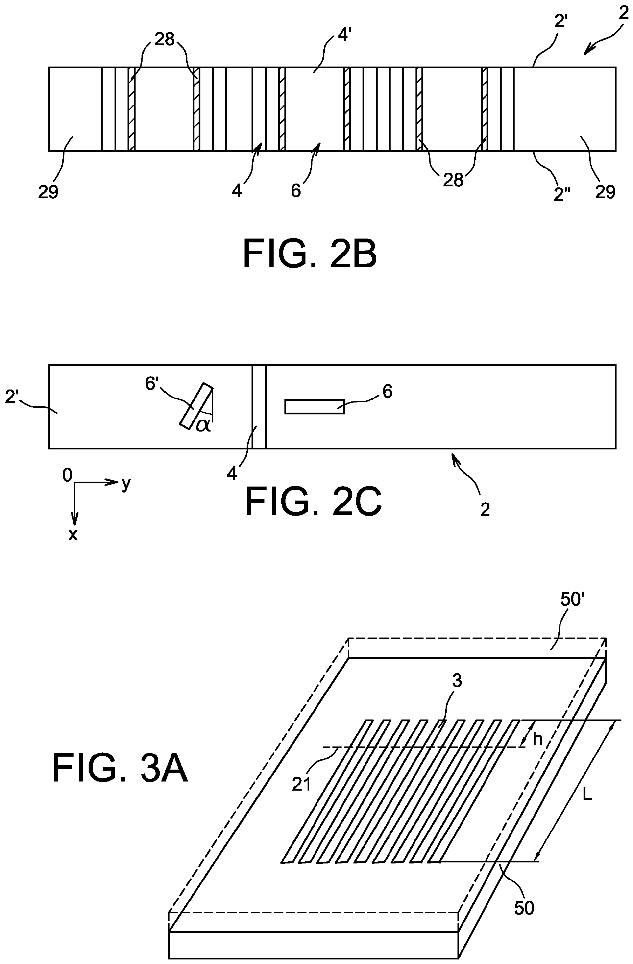

Les figures 2A et 2B illustrent deux autres exemples de structures 3D non couverts par les revendications , pour lesquels tous les composants, tant les composants verticaux 4, 6, que les composants horizontaux 4' sont incorporés dans le substrat reconstitué 2. Seuls un ou des circuits de reroutage peuvent apparaître sur l'une et/ou l'autre des surfaces 2', 2". Le substrat reconstitué obtenu est alors très compact.

L'exemple de la figure 2B - qui pourrait lui aussi comporter des composants horizontaux 4' incorporés dans le substrat reconstitué - présente des composants verticaux 4, 6, dont certains (les composants 6) sont orientés à 90° par rapport aux autres 4. Cette disposition sera mieux comprise à l'aide de la figure 2C qui représente une vue de dessus de la surface 2' du substrat reconstitué de la figure 2B : les deux composants 4, 6 sont montés perpendiculairement au plan xOy du substrat 2, mais avec un angle de 90°, entre eux, dans ce plan. Un autre composant 6' est représenté, avec un autre angle α avec la direction Ox du composant 4 dans ce même plan.

Cette possibilité de disposer des composants formant un angle dans le plan du substrat 2 est particulièrement avantageuse lorsque des capteurs sensibles à la direction sont utilisés. Ainsi, on peut monter plusieurs MEMS de type monoaxial (sensible suivant une seule direction) et/ou bi axial pour réaliser un capteur tri-axial. Par exemple, le composant 4 comporte un MEMS biaxial et le composant 6 comporte un MEMS monoaxial.

Comme il apparaît de la description ci-dessus, il est possible de réaliser des systèmes complexes, reconstitués, à partir de puces individuelles nues (non encapsulées) qui peuvent être préalablement testées ; ces systèmes ne sont pas couverts par les revendications.

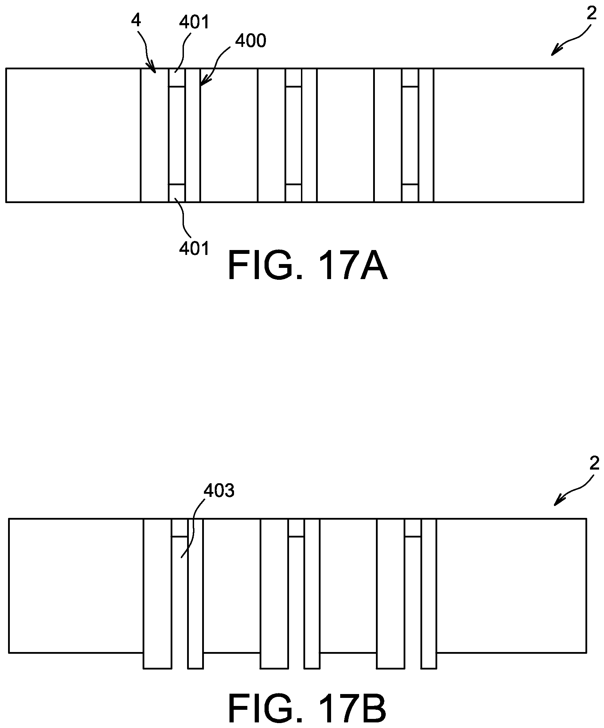

Eventuellement, certains capteurs ou composants fluidiques peuvent nécessiter des accès physiques vers l'extérieur: par exemple une ou des ouvertures pour un ou des composants fluidiques et/ou un ou des capteurs de pressions... Les accès physiques vers l'extérieur peuvent être obtenus de différentes manières. Par exemple, comme illustré sur les figures 17A, 17B, sur lesquelles ne sont pas représentés de manière différenciée le cadre et le matériau d'enrobage, on peut protéger le capteur 4 avec un capot 400 préalablement scellé par un scellement 401 en résine; lors de la fabrication du substrat reconstitué, on réalise un polissage ou un « grinding » de la face arrière et on peut compléter par une gravure plasma pour ouvrir la cavité 403 (figure 17B).

On peut aussi déposer une couche sacrificielle sur une partie de la puce. De la même façon, on ouvre la cavité par grinding, puis gravure plasma, ou en effectuant une dissolution de la résine sacrificielle. On peut aussi prévoir un assemblage des composants qui évite un remplissage de la cavité lors de l'opération d'enrobage.

Selon l'invention les composants intégrés verticalement dans un substrat 2 reconstitué sont des pistes métalliques. Comme on va le voir dans la suite, ceci va notamment permettre de reconstituer un substrat de composants avec un préroutage vertical.

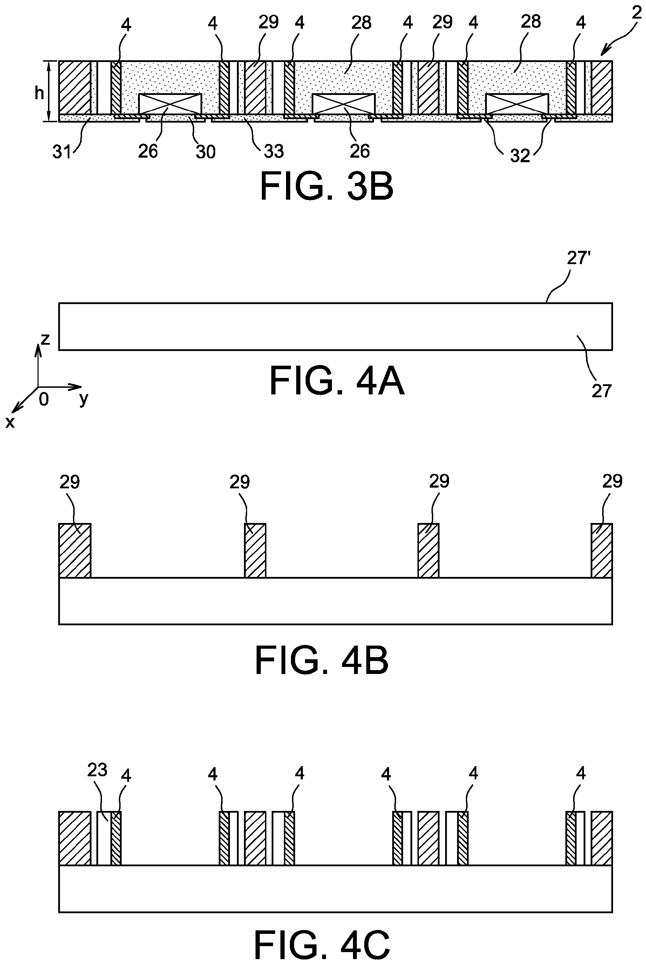

Ainsi, comme illustré sur la figure 3A, on peut préalablement réaliser collectivement, sur un substrat 50, des pistes métalliques 3 de longueur L supérieure à l'épaisseur finale h du substrat 2 reconstitué, qui est illustré en figure 3B. Le substrat sur lequel les pistes 3 sont formées peut être découpé au format adéquat pour former des substrats individuels 5 : ainsi, un trait de découpe 21 est présenté sur la figure 3A, permettant de réaliser une série de pistes ayant la longueur h désirée. La référence 50' désigne un deuxième substrat, qui, selon l'invention, est assemblé au substrat 50 après formation des pistes afin de permettre une meilleure manipulation de l'ensemble ou des composants individuels obtenus après découpage. Ces derniers ont alors une structure similaire à celle représentée en vue de côté en figure 1A, avec les substrats individuels 5, 5'.

Des étapes de procédé pour obtenir un substrat reconstitué selon l'invention et illustré en figure 3B vont être données en liaison avec les figure 4A-4E.

On sélectionne un substrat 27 (figure 4A) dont la surface 27' définit un plan (xOy) qui va déterminer le plan du substrat qui va être reconstitué.

On positionne sur ce substrat 27 un cadre 29 (figure 4B) qui va permettre de délimiter des zones dans chacune desquelles un ou plusieurs composants 4 pourront être disposés.

Les vias 4, obtenus par exemple comme expliqué ci-dessus par découpe du substrat 50 (figure 3A), sont positionnés perpendiculairement à la surface 27' du substrat 27, dans les zones délimitées par le cadre 29 (figure 4C) : l'une de leurs extrémités latérales 3' ou 3" (figure 1A) est positionnée sur cette surface, et la direction de l'empilement substrat 5 - piste métallique 3 - substrat 5' est dirigée parallèlement au plan xOy ou à la surface 27'.

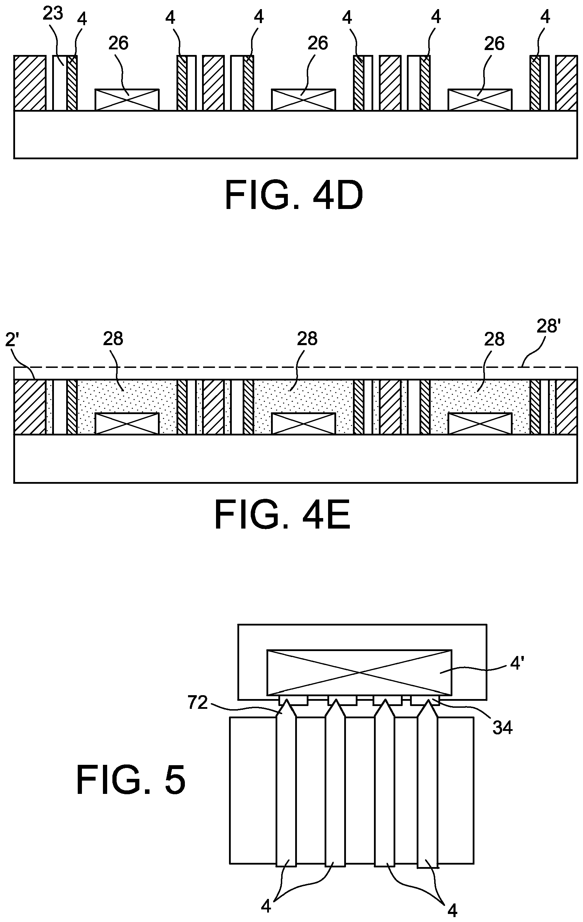

Puis (figure 4D) on dispose des composants 26 pour lesquels les pistes verticales 4 assureront un reroutage vertical. Cette étape (positionnement de composants 26) et la précédente (positionnement des vias 20) peuvent être inversées. Mais chaque puce « nue » (au sens déjà défini ci-dessus, c'est-à-dire une puce non encapsulée) est reportée sur la surface de référence avant enrobage.

Un enrobage 28 de l'ensemble est ensuite réalisé (figure 4E) à l'aide par exemple d'une résine. Les composants ou vias 4 étant incorporés dans le cadre avec leur substrat individuel, un éventuel fluage de la résine ne les affectera pas.

Si l'enrobage dépasse le sommet des vias 4, comme illustré sur la figure 4E où la référence 28' représente un niveau d'enrobage en excès, un amincissement ou un surfaçage de l'ensemble permet d'atteindre la surface 2' qui fait apparaître des zones conductrices 72, 74 correspondant à l'extrémité supérieure des vias 4. On a ainsi formé une surface 2' de connexion, dans laquelle affleurent les zones conductrices formées par les extrémités conductrices 72, 74 des vias 4. Cette surface de connexion permettra, ultérieurement, d'accueillir par exemple un étage supplémentaire de composants en vue de la réalisation d'un empilement d'étages.

Enfin, il est procédé au décollement du support 27 et à une passivation de la surface laissée ainsi libre. On peut notamment réaliser une couche de matériau diélectrique photosensible 31 (figure 3B), et graver dans cette couche des ouvertures 32, à partir desquelles il sera possible d'établir des connexions entre les composants 26 et les vias 4, et éventuellement d'un composant 26 à un autre situé dans le même plan. Par exemple, on réalise ces connexions externes, ou ce reroutage arrière, par une étape de métallisation sur la face 33 de la couche 31 opposée à la face de cette couche sur laquelle les composants 26 reposent. Les vias 4 peuvent servir de motif d'alignement pour des étapes de photolithographie sur la face arrière.

Comme déjà expliqué ci-dessus, chaque substrat individuel et son composant, ce dernier correspondant à la partie électronique et/ou mécanique de la puce, avec ses pistes et ses moyens de connexion, forment une puce non encapsulée qui est reportée sur la surface de référence avant enrobage. Les pistes et les moyens de connexion sont intégrés dans la puce et seules les extrémités ou bornes de ces moyens de connexion affleurent.

Un reroutage en face avant 2' peut également être réalisé, comme déjà expliqué ci-dessus. C'est par exemple une métallisation en cuivre. Une passivation peut être réalisée au-dessus du métal du reroutage.

Afin d'assurer un meilleur contact avec un composant extérieur ou un composant 4' disposé en surface 2' du substrat reconstitué (comme le composant 4' de la figure 1D), l'extrémité 72 des vias 4 peut être en forme tronconique ou de pointes (figure 5). Ces pointes peuvent venir en contact de plots 34 du composant 4'. Elles peuvent également venir en contact avec un ou des composants ou un ou des vias d'un étage supérieur positionné au-dessus de l'étage 2. Cela permet de réaliser simultanément les vias et des moyens d'interconnexion avec un autre étage supérieur.

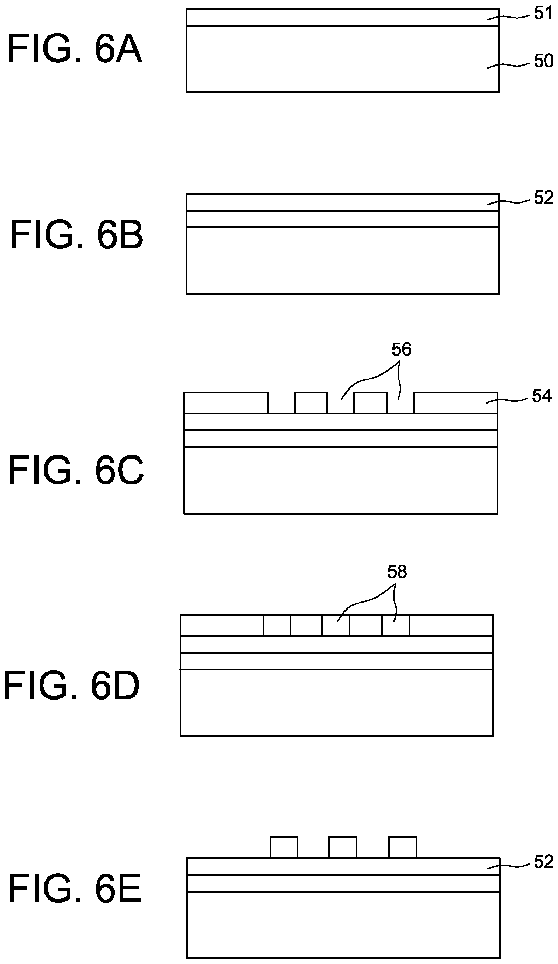

Les figures 6A-6G sont des étapes d'un exemple de fabrication de vias sur des puces.

Comme illustré sur la figure 6A, on procède d'abord au dépôt d'une couche isolante 51, par exemple en SiO2, sur le substrat 50.

On procède ensuite (figure 6B) au dépôt d'une couche 52 conductrice par exemple un alliage Ti/Cu.

Par photolithographie on délimite les zones d'électrolyse d'un métal, par exemple du cuivre. La référence 54 désigne un masque de résine comportant les ouvertures 56 permettant de délimiter ces zones.

La croissance de métal, par électrolyse, peut ensuite être réalisée dans les ouvertures 56 (figure 6D). La résine 54 est ensuite éliminée (figure 6E), laissant subsister des bandes 58 sur le fond continu 52. Celui-ci est ensuite gravé (figure 6F). Pratiquement, à ce stade, on obtient la structure de la figure 3A, sans le substrat 5'. Puis les puces sont découpées aux tailles souhaitées.

Selon l'invention, comme illustré sur la figure 6G, l'ensemble ainsi obtenu est assemblé avec un subtrat 50', par exemple par l'intermédiaire d'une couche diélectrique 51', pour permettre la manipulation et la rotation de la puce.

Le procédé selon l'invention décrit ci-dessus permet de réaliser un substrat reconstitué dans lequel les composants disposés verticalement sont des vias conducteurs. En dehors du cadre de l'invention revendiquée, on comprendra que ce type de procédé peut être appliqué à tout autre type de composant ou d'empilement de composants plus complexes, par exemple des MEMS, avec vias dans le substrat. Pour chaque puce individuelle à positionner verticalement, un préroutage 69 (figures 1A-1C) formé en surface du substrat 5, 7 permet de relier les moyens de connexion électrique 72, 74 qui débordent du substrat 5, 7 ou qui sont situés à proximité d'un côté, ou des côtés opposés 3', 3" du substrat sur lequel la puce 3, 7 est réalisée. Ces connexions 72, 74 permettent ensuite de reconnecter les différents composants du substrat reconstitué, par formation d'un reroutage sur la ou les surface 2' ou 2", comme déjà expliqué ci-dessus.

Les figures 7A et 7B présentent des exemples de composants passifs, 64, 66, 68 réalisés sur un substrat 5, par exemple en silicium. Ces componsants ne sont pas en eux-mêmes couverts par les revendications.

Ces composants passifs peuvent réaliser, sur un même substrat 5, un ensemble de fonction, comme par exemple les composants passifs 64, 66 de la figure 7A (ici : une capacité et une résistance), ou constituer un ensemble d'éléments identiques comme les composants passifs 68 de la figure 7B (ici : deux inductances).

La surface du substrat 5 qui porte chaque composant ou chaque ensemble de composants est muni d'un préroutage 69 qui est relié, comme expliqué ci-dessus en liaison avec la figure 1A, à une ou des sorties latérales des contacts 72, 74 de la puce.

Préférentiellement, quels que soient (le ou) les composants réalisés en surface, on réalise un ou plusieurs évidements 70, 73 dans le prolongement du préroutage 69 et dans lequel les éléments de connexion 72, 74 débouchent. Chaque évidement a sensiblement la forme d'une fente parallèle à l'un des côtés 3', 3" et pourra être rempli par un matériau isolant. Ce matériau permettra un isolement au niveau de chaque surface 2', 2" du substrat, puisque ces surfaces seront en fait formées, après reconstitution, en partie par les bords 3, 3' des substrats sur lesquels les composants sont réalisés et en partie par le matériau d'enrobage 28 (comme sur la figure 3B).

Eventuellement un composant ne dispose d'un préroutage et de moyens de connexion que sur un seul côté, par exemple comme illustré en figure 7C où les pistes 69 relient un composant 65 à des éléments de connexion 72 situés uniquement sur un des côtés 3' du substrat 5.

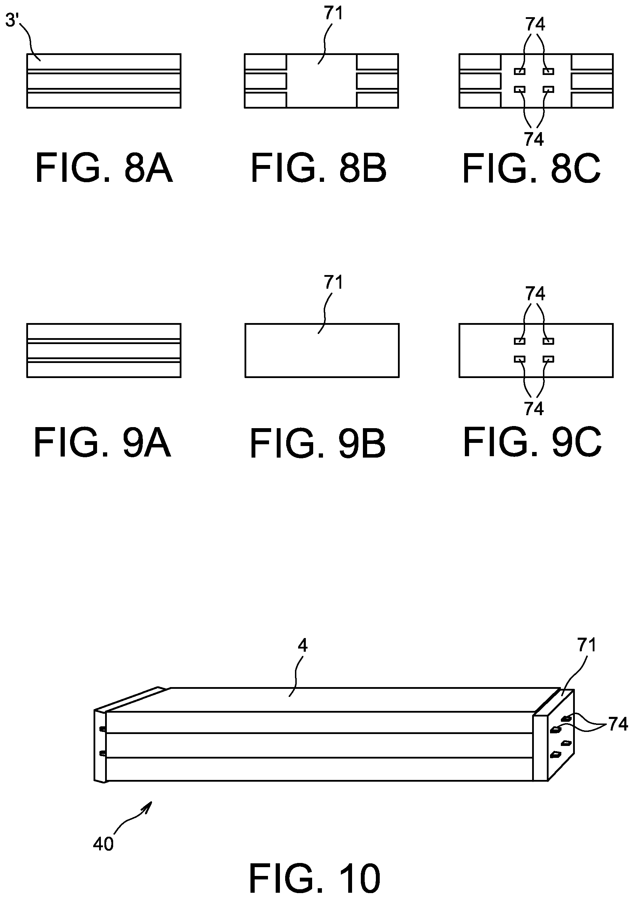

Avant reconstitution d'un substrat 2, de tels composants élémentaires peuvent être assemblés ou empilés, selon différentes méthodes, comme expliqué ci-dessous en liaison avec les figures 8A-8C et 9A-9C.

Ainsi, sur la figure 8A sont représentés trois composants empilés. Les composants sont vus selon la direction indiquée sur la figure 7A par la flèche B. Le côté 3' du substrat 5 de cette figure 7A est d'ailleurs également identifié sur la figure 8A.

Cet assemblage peut être ensuite rectifié (étape de « grinding »), selon une direction en parallèle à la direction AA' identifiée sur les figures 7A et 7B, c'est-à-dire depuis l'un et/ou l'autre des côtés 3', 3", jusqu'à faire apparaître le matériau 71 de remplissage de la cavité 70. Si cette étape de rectification est poursuivie, on voit apparaître les extrémités des éléments de connexion 74, comme illustré sur la figure 8C. Cette étape de rectification de l'ensemble des substrats permet donc de faire apparaître les zones remplies par le matériau isolant, puis les extrémités du préroutage.

Le cas des figures 9A-9C est celui d'un empilement de substrats, tels que ceux des figures 7A-7C, mais pour lesquels l'une des cavités 70 a une largeur identique à la largeur 1 (voir figure 7A) du substrat 5. L'opération de rectification fait donc apparaître le matériau 71 de remplissage de cette cavité, mais sur la largeur sensiblement égale à celle, l, du substrat 5. Si la rectification est poursuivie, dans la même direction, les extrémités des éléments de connexion 74 apparaissent (figure 9C).

Les mêmes opérations de rectification peuvent être réalisées à partir de l'extrémité 3" du substrat 5.

Par conséquent, selon la taille des cavités 70, 73 et les dimensions de la découpe, on peut totalement, ou presque totalement, éliminer le matériau du substrat 5 en surface du substrat reconstitué par empilement. Il est d'ailleurs préférable de ne pas laisser le matériau semi-conducteur à nu.

La figure 10 représente, en vue de côté, un ensemble 40 de composants 4 empilés, après l'opération de rectification : à l'une des extrémités de cet empilement, apparaissent à la fois le matériau de remplissage 71, qui recouvre entièrement les côtés des substrats individuels, et les extrémités des éléments de connexion 74. On obtient un assemblage de composants qui peut être directement incorporé verticalement dans un substrat reconstitué.

Dans les exemples donnés ci-dessus, les évidements 70, 73 sont remplis avec le matériau de remplissage 71 avant assemblage des puces. En variante on peut aussi découper les puces, puis les empiler et les assembler avec un matériau qui servira au collage et au remplissage.

L'incorporation de composants individuels, tels ceux des figures 7A-7C, ou d'empilements 40 de tels composants, comme ceux des figures 8C, 9C ou 10, dans un substrat reconstitué peut être réalisé à l'aide d'un procédé similaire à celui décrit ci-dessus en liaison avec les figures 4A-4C (positionnement d'un cadre sur un substrat, positionnement des composants perpendiculairement au substrat, enrobage). Les extrémités des éléments de connexion 72, 74 affleurent la surface 2' et/ou 2" du substrat reconstitué 2, ou apparaissent au niveau de cette ou de ces surface(s).

La figure 11 représente un tel substrat reconstitué 2, non couvert par les revendications, comprenant plusieurs assemblages, tels que les assemblages 40 de la figure 10, incorporés verticalement. Le substrat peut être éventuellement rodé sur l'une et/ou l'autre de ses faces 2', 2", pour libérer les préroutages.

Ensuite, par des procédés standards de la microélectronique tels que ceux déjà indiqués ci-dessus, on réalise une ou des connexions entre les divers composants ou à l'intérieur du composant lui-même : ainsi, sur la figure 11 sont représentés des connexions 11-1 entre deux ensembles ou groupes de composants et des connexions 11-2 à l'intérieur d'un même groupe de composants empilés.

Selon les cas de figure, on peut avoir un préroutage sur une et/ou l'autre des deux faces 2', 2".

Les figures 12A et 12B représentent un autre exemple de préparation d'un composant 4, en lui-même non couvert par les revendications, en vue de son intégration dans un dispositif. Dans cet exemple, le composant lui-même est un MEMS 82 recouvert d'un capot ou d'une protection 84 ; cette structure peut s'appliquer à d'autres composants.

A partir du composant 82, on réalise des pistes 69 de préroutage ou de connexion, puis on grave des cavités 80 dans le substrat 5, sous ces pistes 69.

On dépose ensuite (figure 12B) sur la surface du substrat 5 et dans les cavités 80 un matériau isolant 86. Les cavités 80 et ce matériau 86 jouent, dans cet exemple, un rôle similaire aux évidements 70,73 et au matériau 71 de remplissage des figures 7A et 7B. Le matériau isolant peut déborder au-delà des extrémités 72, 74, ce qui peut nécessiter ensuite une opération d'amincissement comme expliqué ci-dessous.

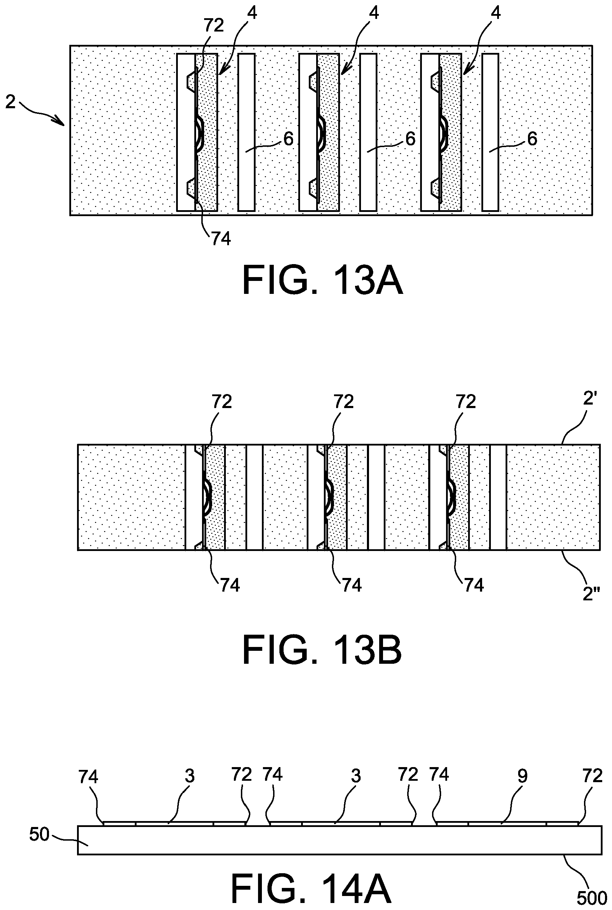

Les figures 13A et 13B montrent un exemple d'incorporation de composants du type MEMS, par exemple du type décrit ci-dessus en liaison avec les figures 12A et 12B, en vue de la formation d'un substrat 2 reconstitué, non couvert par les revendications. Ce dernier peut être obtenu par un procédé similaire à celui décrit ci-dessus en liaison avec les figures 4A- 4E. D'autres composants 6 peuvent être incorporés dans le même substrat reconstitué, par les mêmes étapes de procédé.

On voit sur la figure 13A que les extrémités 72, 74 des éléments de connexion des composants 4 ne sont pas accessibles de l'extérieur. On procède donc à une étape supplémentaire d'amincissement du substrat reconstitué, de manière à ce que lesdites extrémités soient accessibles au niveau des surfaces 2', 2" (figure 13B).

Préférentiellement, on peut éliminer, par un procédé d'amincissent (rodage, gravure ...), avant l'intégration des composants dans le substrat, le matériau des composants (par exemple : silicium) qui serait apparent. Pour éviter d'avoir du silicium apparent, on peut ainsi amincir les puces et éliminer le silicium sous les cavités. Ensuite, on monte les puces dans le substrat reconstitué.

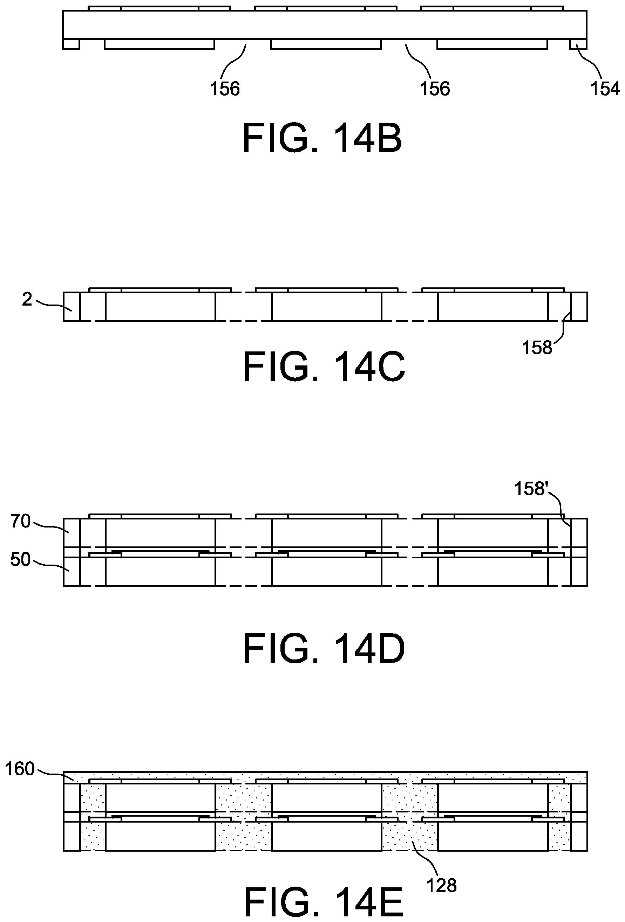

Un autre exemple de mise en oeuvre d'un procédé, non couvert par les revendications ,est illustré sur les figures 14A - 14I.

Tout d'abord (figure 14A), on réalise collectivement divers composants électroniques 3, 9 sur la face, dite face avant, d'un substrat 50. On réalise donc, par exemple, un ou plusieurs composants passifs et/ou un ou plusieurs composants de type MEMS.

Puis (figure 14B), par photolithographie à l'aide d'un masque 154, on délimite des évidements 156 qui vont permettre de réaliser une gravure du substrat par sa face arrière 500.

On procède ensuite à une gravure anisotrope du substrat 50 à travers ces évidements 156 (figure 14C). Sont ainsi formés des cavités 158 dans ce même substrat, sous les extrémités 72, 74 de connexion et éventuellement partiellement sous les pistes 69.

Lors d'une étape ultérieure (figure 14D), le premier étage ainsi réalisé peut-être assemblé, par exemple par collage, avec un deuxième étage, comportant lui aussi une pluralité de composants, identiques ou différents de ceux du premier étage, formés en surface d'un substrat 70. Ce deuxième étage peut être formé de manière similaire au premier.

Les évidements 158, 158' peuvent être remplis avec un produit d'enrobage 128 (par exemple une résine époxy). Un renforcement de la structure peut être obtenu par surépaisseur 160 de ce produit d'enrobage.

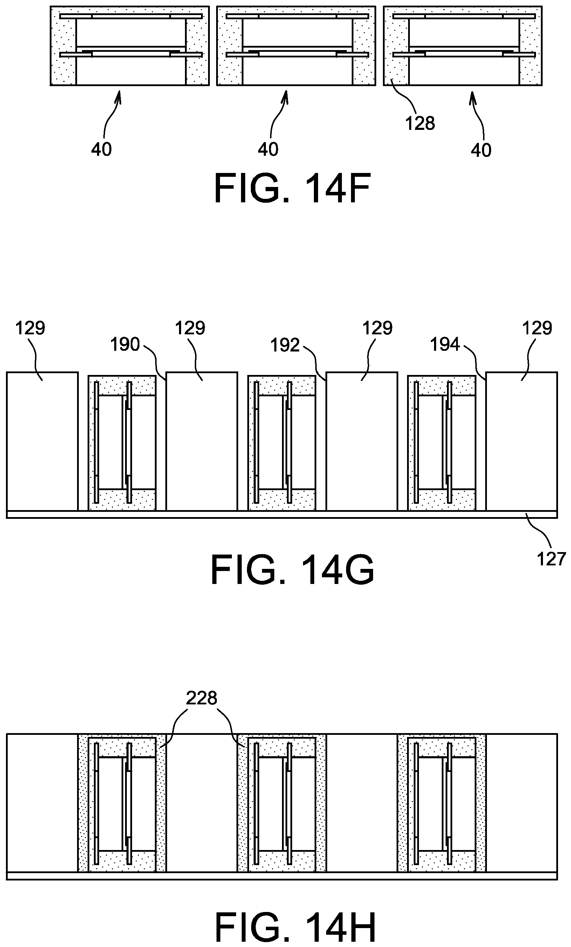

Les structures ainsi réalisées peuvent ensuite être découpées (figure 14F). On obtient donc des empilements 40, comportant chacun deux composants individuels superposés.

Ces différents empilements 40 peuvent être positionnées et fixées sur un substrat ou une plaque, ou sur un élément adhésif 127, par exemple à l'aide d'un cadre 129 présentant des ouvertures 190, 192, 194 (figure 14G, qui illustre, comme en figures 14H-14I, une structure non couverte par les revendications), dont la largeur ou le diamètre permet une introduction de ces empilements, de manière « verticale » ou perpendiculairement au plan défini par la plaque 127. En fait c'est la surface plane de cette plaque ou substrat 127 qui va déterminer le plan du substrat qui va être reconstitué.

Ces ouvertures peuvent ensuite être comblées, par exemple à l'aide d'un matériau d'enrobage 228 tel qu'une résine (figure 14H).

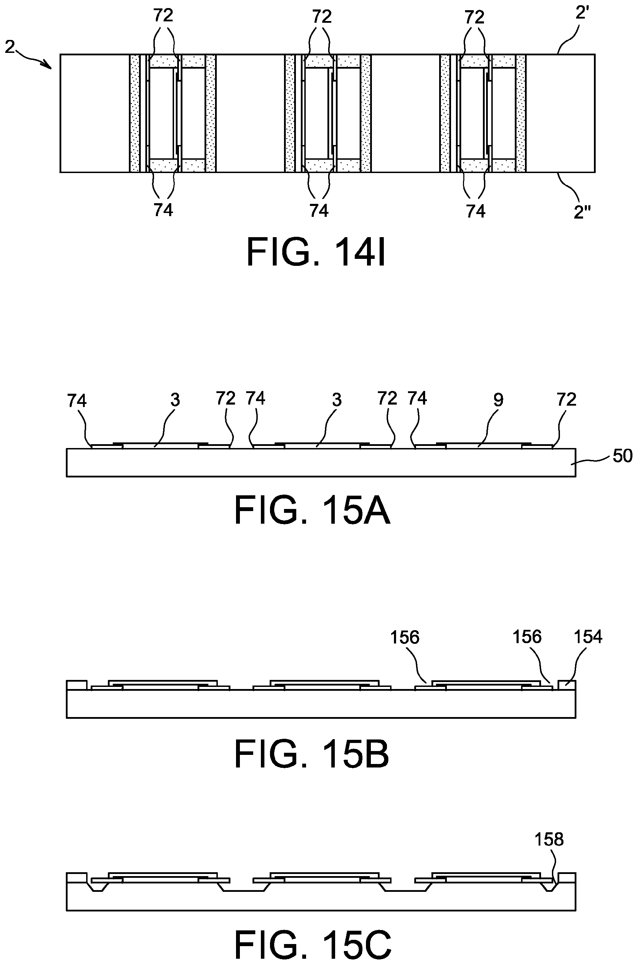

Enfin, on procède à une étape d'amincissement (« grinding ») pour libérer les connexions (figure 14I) et faire en sorte que leurs extrémités 72, 74, ou plots de connexion, soient accessibles depuis l'une et/ou l'autre des faces 2', 2" du substrat ainsi reconstitué 2. Un reroutage 11, 11' de surface peut ensuite être réalisé à partir de ces plots.

Un autre exemple de mise en oeuvre d'un procédé, non couvert par les revendications, est illustré sur les figures 15A-15F.

Tout d'abord (figure 15A), on réalise collectivement diverses fonctions électroniques sur une face, dite face avant, d'un substrat 50. On réalise donc, par exemple, un ou plusieurs composants 3, 9 passifs et/ou MEMS. Les références 72, 74, désignent là encore des éléments de connexion à ces divers composants.

Puis (figure 15B), par photolithographie à l'aide d'un masque 154, on délimite des évidements 156 qui vont permettre de réaliser une gravure du substrat par sa face avant, entre des composants voisins.

On procède ensuite à une gravure anisotrope du substrat 50 à travers ces évidements 156 (figure 15C). Sont ainsi formés des cavités 158 dans ce même substrat, au-dessus desquelles les plots de connexion 72, 74, et éventuellement une partie des pistes 69, sont libres.

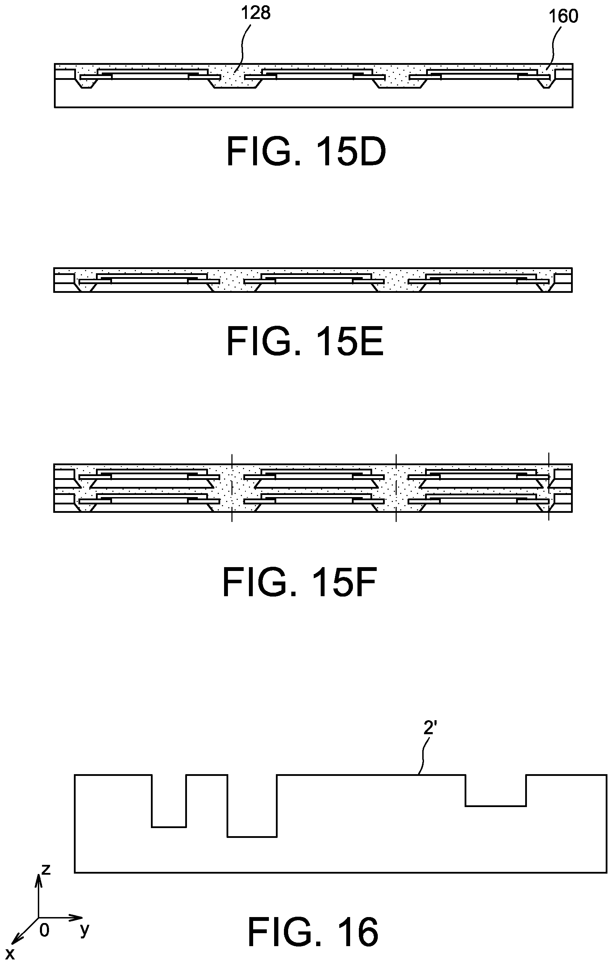

Les cavités peuvent ensuite être remplies à l'aide d'un matériau d'enrobage 128 tel qu'une résine (figure 15D). Un renforcement de la structure peut être obtenu par surépaisseur 160 de ce produit d'enrobage.

On procède ensuite à un amincissement du substrat 50 (figure 15E), et éventuellement à un collage avec un deuxième étage, comme déjà expliqué dans le mode de réalisation ci-dessus.

Ensuite, on retrouve les étapes décrites dans le premier exemple, en particulier les étapes décrites en liaison avec les figures 14G-14I, non couvertes par les revendications, les composants assemblés pouvant être découpés selon les lignes en traits interrompus de la figure 15F.

Dans les divers exemples donnés ci-dessus, les deux faces extérieures 2', 2'' du composant 2 reconstitué sont accessibles, et permettent notamment de réaliser un reroutage horizontal à partir des éléments de connexion des composants qui apparaissent à ces surfaces.

Mais il est également possible de disposer les composants dans un substrat ayant une forme telle qu'indiqué en figure 16. Dans ce substrat, qui ne fait pas partie de l'invention revendiquée, sont réalisées, par exemple par gravure, des cavités, qui peuvent avoir des profondeurs différentes l'une de l'autre. Ces cavités permettent d'accueillir des composants selon une direction perpendiculaire à un plan xOy défini par le substrat. Ces cavités ne sont pas traversantes, ce qui signifie que seule une des faces 2' du substrat peut être utilisée pour un reroutage de surface. Le maintien des composants dans les diverses cavités peut être réalisé à l'aide, là encore, d'un matériau d'enrobage.

L'invention peut être utilisée pour la réalisation de modules de mémoires à haute vitesse, car elle permet de réduire les longueurs de pistes et d'empiler des puces.

On peut aussi intégrer des micro-batteries, et/ou des MEMS, avec ou sans ouvertures vers l'extérieur, et/ou un réseau de capteurs. L'invention peut aussi être utilisée pour réaliser des systèmes communicants et nomades. On peut ainsi réaliser en surface 2' ou 2" des antennes de communication.

L'invention permet d'incorporer une multitude de fonctions différentes ou identiques et de créer des blocs (par exemple des blocs mémoires) ou des systèmes complets, en effectuant l'interconnexion entre ces blocs ou systèmes.

L'interconnexion est réalisée entre les puces ou entre des systèmes par des procédés standards de la microélectronique, sur une face ou sur les deux faces 2', 2" du substrat reconstitué 2. L'utilisation des deux faces permet aussi de réaliser un empilement supplémentaire, par exemple d'empiler deux substrats reconstitués.

Il a été indiqué qu'un procédé selon l'invention peut comporter une éventuelle étape d'amincissement. Cette étape permet notamment d'éliminer la surépaisseur 28' de matériau d'enrobage ou encore de passer de la figure 13A à la figure 13B ou de la figure 14H à la figure 14I. Afin de la faciliter, les puces ou composants 4, 6, 40 peuvent contenir des mires de contrôle de la profondeur de l'amincissement. Par exemple, on observe l'apparition de mires à certaines altitudes dans le substrat. On peut réaliser des profils de mires qui permettent, grâce à une mesure dimensionnelle, de connaître la profondeur de l'amincissement.

D'une manière générale, l'invention permet d'intégrer, dans un même substrat, des composants de tailles différentes. On place dans le substrat reconstitué des puces de tailles différentes, puis on réalise un enrobage pour encapsuler toutes les puces. Quand le substrat est réalisé on traite la face qui comporte les connexions. Dans le cas du brevet US 5 688 721, on ne peut utiliser des composants de tailles différentes qu'en montant des puces postiches pour réaliser une structure stable.

Selon divers aspects complémetaires qui ne font pas partie de l'invention revendiquée :
- au moins deux substrats supports individuels peuvent être disposés perpendiculairement à ladite surface, en formant entre eux un angle non nul. Ceci peut être avantageux pour la réalisation de capteurs directionnels ;
- au moins deux substrats supports individuels peuvent être empilés, les deux substrats étant ensuite positionnés ensemble, perpendiculairement à ladite surface de référence.
- au moins un substrat support individuel peut être muni, sur un de ses côtés, d'un matériau d'enrobage.

## Revendications

1. Procédé de réalisation d'un dispositif électronique reconstitué comportant, entre une première et une deuxième faces, une pluralité de vias (4), chaque via comportant une série de pistes métalliques (3) comprises entre 2 substrats (50, 50'), chaque piste métallique ayant un premier contact latéral et un deuxième contact latéral (72, 74), chaque via comportant un premier côté (3') et un deuxième côté (3") opposé au premier, lesdits premiers contacts latéraux (72) dépassant ou affleurant le premier côté et lesdits deuxièmes contacts latéraux (74) dépassant ou affleurant le deuxième côté, chaque via interconnectant les première et deuxième faces, ledit procédé comportant :
a) le positionnement d'un cadre (29, 129), sur une surface (27', 127) de référence d'un support (27) ou d'une surface adhésive (127), ce cadre délimitant des zones dans chacune desquelles un ou plusieurs vias peut ou peuvent être positionné(s),
b) le positionnement du deuxième côté (3', 3") de chaque via sur ladite une surface (27', 127) de référence, de sorte que chacun des substrats de chaque via soit disposé perpendiculairement à ladite surface de référence, qui définit la première (2') face du dispositif électronique reconstitué, et le positionnement d'au moins un composant (26) horizontalement sur ladite surface (27', 127) de référence;
c) puis l'enrobage des vias et dudit composant avec un matériau d'enrobage (28), pour combler les espaces entre le cadre, ledit composant et les vias, et maintenir les vias, ledit composant et le support (27) ou la surface adhésive, de sorte que les contacts latéraux (72, 74) situés du premier côté de chaque via, affleurent la deuxième face du dispositif électronique reconstitué.

2. Procédé selon la revendication 1, comportant en outre une étape de réalisation de pistes de connexions (11, 11') sur la première face et/ou la deuxième face du dispositif électronique reconstitué.

3. Procédé selon l'une des revendications 1 ou 2, l'étape c) comportant un amincissement du dispositif reconstitué de manière à ce que lesdits premiers contacts latéraux (72, 74) de chaque via affleurent la deuxième face du substrat reconstitué.

4. Procédé selon l'une des revendications 1 à 3, le procédé comportant en outre, après l'étape c), l'établissement d'une connexion électrique entre le composant diposé horizontalement sur ladite surface (27', 127) de référence et une piste métallique (3) d'un via (4) .

5. Procédé selon l'une des revendications 1 à 4, ledit composant (26) disposé horizontalement sur ladite surface (27', 127) de référence étant d'épaisseur inférieure à celle du dispositif électronique reconstitué.

6. Procédé selon l'une des revendications 1 à 5, ledit composant (26) disposé horizontalement sur ladite surface (27', 127) de référence étant, dans un plan perpendiculaire à cette dernière et après l'étape c), entouré latéralement de matériau d'enrobage et recouvert de matériau d'enrobage jusqu'à la deuxième face (2") du dispositif électronique reconstitué.

7. Dispositif électronique reconstitué (2) comportant :
- une première face et une deuxième face,
- une pluralité de vias (4), chaque via comportant une série de pistes métalliques entre 2 substrats (50, 50') et chaque piste métallique ayant un premier contact latéral et un deuxième contact latéral (72, 74), chaque via comportant un premier côté (3') et un deuxième côté (3") opposé au premier côté, lesdits premiers contacts latéraux (72) dépassant ou affleurant le premier côté et lesdits deuxièmes contacts latéraux (74) dépassant ou affleurant le deuxième côté, lesdits substrats étant disposés perpendiculairement auxdites faces, lesdits premiers contacts latéraux (72) affleurant ladite deuxième face du substrat reconstitué, lesdits deuxièmes contacts latéraux (74) affleurant ladite première face du substrat reconstitué, chaque via interconnectant lesdites première et deuxième faces du substrat reconstitué,
- au moins un composant (26) incorporé dans le dispositif reconstitué, disposé parallèlement auxdites première face et deuxième face et affleurant une de ces deux faces,
- et un matériau d'enrobage (28, 128) qui comble les espaces entre ledit au moins un composant (26) et les vias, et qui les maintient.

8. Dispositif selon la revendication 7, comportant en outre une ou plusieurs pistes de connexions (11, 11') sur la première et/ou la deuxième face du dispositif électronique reconstitué.

9. Dispositif selon l'une des revendications 7 ou 8, une connexion électrique étant établie entre une piste métallique (3) et le composant (26).

10. Dispositif selon l'une des revendications 7 à 9, ledit composant (26) étant d'épaisseur inférieure à la distance entre la première face et la deuxième face qui définit l'épaisseur du dispositif électronique reconstitué.

11. Dispositif selon l'une des revendications 7 à 10, ledit composant (26) incorporé dans le dispositif électronique reconstitué, disposé parallèlement auxdites première face et deuxième face, et affleurant une de ces deux faces, étant, dans un plan perpendiculaire à ces dernières, entouré latéralement du matériau d'enrobage et recouvert du matériau d'enrobage jusqu'à l'autre face du dispositif électronique reconstitué.

## Patentansprüche

1. Verfahren zur Herstellung einer rekonstituierten elektronischen Vorrichtung, die zwischen einer ersten und einer zweiten Fläche eine Mehrzahl von Durchführungen (4) umfasst, wobei jede Durchführung eine Reihe von Metallbahnen (3) umfasst, die zwischen zwei Substraten (50, 50') enthalten sind, wobei jede Metallbahn einen ersten lateralen Kontakt und einen zweiten lateralen Kontakt (72, 74) hat, wobei jede Durchführung eine erste Seite (3') und eine zweite Seite (3") entgegengesetzt zur ersten hat, wobei die ersten lateralen Kontakte (72) über die erste Seite hinaus ragen oder damit fluchten, und die zweiten lateralen Kontakte (74) über die zweite Seite hinaus ragen oder damit fluchten, wobei jede Durchführung die erste und die zweite Fläche miteinander verbindet, wobei das Verfahren umfasst:
a) Positionieren eines Rahmens (29, 129) auf einer Referenzoberfläche (27', 127) eines Trägers (27) oder einer Haftoberfläche (127), wobei dieser Rahmen Zonen begrenzt, in jeder von denen eine oder mehrere Durchführungen positioniert sein kann oder können,
b) Positionieren der zweiten Seite (3', 3") jeder Durchführung auf der einen Referenzoberfläche (27', 127) derart, dass jedes der Substrate von jeder Durchführung orthogonal zu der Referenzoberfläche angeordnet ist, die die erste (2') Fläche der rekonstituierten elektronischen Vorrichtung definiert, und Positionieren wenigstens einer Komponente (26) horizontal auf der Referenzoberfläche (27', 127);
c) dann Verkleiden der Durchführungen und der Komponente mit einem Verkleidungsmaterial (28), um die Räume zwischen dem Rahmen, der Komponente und den Durchführungen aufzufüllen und die Durchführungen, die Komponente und den Träger (27) oder die Haftoberfläche zu halten, derart, dass die lateralen Kontakte (72, 74), die sich auf der ersten Seite jeder Durchführung befinden, mit der zweiten Fläche der rekonstituierten elektronischen Vorrichtung fluchten.

2. Verfahren nach Anspruch 1, ferner umfassend einen Schritt der Realisierung von Verbindungsbahnen (11, 11') auf der ersten Fläche und/oder der zweiten Fläche der rekonstituierten elektronischen Vorrichtung.

3. Verfahren nach einem der Ansprüche 1 oder 2, wobei der Schritt c) ein Abdünnen der rekonstituierten Vorrichtung derart umfasst, dass die ersten lateralen Kontakte (72, 74) jeder Durchführung mit der zweiten Fläche des rekonstituierten Substrats fluchten.

4. Verfahren nach einem der Ansprüche 1 bis 3, wobei das Verfahren ferner nach dem Schritt c) die Herstellung einer elektrischen Verbindung zwischen der Komponente, die horizontal auf der Referenzoberfläche (27', 127) angeordnet ist, und einer Metallbahn (3) einer Durchführung (4) umfasst.

5. Verfahren nach einem der Ansprüche 1 bis 4, wobei die Komponente (26), die horizontal auf der Referenzoberfläche (27', 127) angeordnet ist, eine Dicke hat, die kleiner ist als jene der rekonstituierten elektronischen Vorrichtung.

6. Verfahren nach einem der Ansprüche 1 bis 5, wobei die Komponente (26), die horizontal auf der Referenzoberfläche (27', 127) angeordnet ist, in einer Ebene orthogonal zu letzterer und nach dem Schritt c) lateral von Verkleidungsmaterial umgeben und mit Verkleidungsmaterial bis zur zweiten Fläche (2") der rekonstituierten elektronischen Vorrichtung bedeckt ist.

7. Rekonstituierte elektronische Vorrichtung (2) umfassend:
- eine erste Fläche und eine zweite Fläche,
- eine Mehrzahl von Durchführungen (4), wobei jede Durchführung eine Reihe von Metallbahnen zwischen zwei Substraten (50, 50') umfasst, und jede Metallbahn einen ersten lateralen Kontakt und einen zweiten lateralen Kontakt (72, 74) hat, wobei jede Durchführung eine erste Seite (3') und eine zweite Seite (3") entgegengesetzt zur ersten Seite umfasst, wobei die ersten lateralen Kontakte (72) über die erste Seite hinaus ragen oder damit fluchten, und die zweiten lateralen Kontakte (74) über die zweite Seite hinaus ragen oder damit fluchten, wobei die Substrate orthogonal zu den Flächen angeordnet sind, wobei die ersten lateralen Kontakte (72) mit der zweiten Fläche des rekonstituierten Substrats fluchten, wobei die zweiten lateralen Kontakte (74) mit der ersten Fläche des rekonstituierten Substrats fluchten, wobei jede Durchführung die erste und die zweite Fläche des rekonstituierten Substrats miteinander verbindet,
- wenigstens eine Komponente (26), die in die rekonstituierte Vorrichtung eingefügt, parallel zu der ersten Fläche und der zweiten Fläche angeordnet ist und mit einer dieser zwei Flächen fluchtet,
- und ein Verkleidungsmaterial (28, 128), das die Räume zwischen der wenigstens einen Komponente (26) und den Durchführungen auffüllt, und das sie hält.

8. Vorrichtung nach Anspruch 7, ferner umfassend eine oder mehrere Verbindungsbahnen (11, 11') auf der ersten und/oder der zweiten Fläche der rekonstituierten elektronischen Vorrichtung.

9. Vorrichtung nach einem der Ansprüche 7 oder 8, wobei eine elektrische Verbindung zwischen einer Metallbahn (3) und der Komponente (26) hergestellt ist.

10. Vorrichtung nach einem der Ansprüche 7 bis 9, wobei die Komponente (26) eine Dicke hat, die kleiner ist als der Abstand zwischen der ersten Fläche und der zweiten Fläche, der die Dicke der rekonstituierten elektronischen Vorrichtung definiert.

11. Vorrichtung nach einem der Ansprüche 7 bis 10, wobei die Komponente (26), die in die rekonstituierte elektronische Vorrichtung eingefügt ist, parallel zu der ersten Fläche und der zweiten Fläche angeordnet ist, und mit einer dieser zwei Flächen fluchtet, in einer Ebene orthogonal zu diesen letzteren lateral von Verkleidungsmaterial umgeben ist und bis zur anderen Fläche der rekonstituierten elektronischen Vorrichtung mit Verkleidungsmaterial bedeckt ist.

## Claims

1. Method of producing a reconstituted electronic device comprising, between a first face and a second face, a plurality of vias (4), each via comprising a series of metal tracks (32) comprised between 2 substrates (50, 50'), each metal track having a first lateral contact and a second lateral contact (72, 74), each via comprising a first side (3') and a second side (3") opposite to the first, said first lateral contacts (72) projecting beyond or being flush with, the first side, said second lateral contacts (74) projecting beyond or being flush with, the second side, each via interconnecting the first and second faces, said method comprising:
a) positioning of a frame (29, 29') on a reference surface (27', 127) of a support (27) or of an adhesive surface (127), this frame delimiting zones in each of which one or more vias can be positioned
b) the positioning of the second side (3', 3") of each via on said reference surface (27', 127), so that each of said substrates is placed perpendicular to said reference surface, which defines the first face (2') of the reconstituted electronic device and the positioning of at least one component (26) horizontally on said reference surface (27', 127);
c) then the encapsulation of the vias and of said component with an encapsulant (28) to fill the spaces between the frame, said component and said vias and maintain said vias, said component and the support (27) or the adhesive surface so that the lateral contacts (72, 74) located on the first side of each via are flush with the second face of the reconstituted electronic device.

2. Method according to claim 1, further comprising a step of forming connection tracks (11, 11') on the first and/or the second face of the reconstituted electronic device.

3. Method according to one of claims 1 or 2, step c) comprising a thinning of the reconstituted device so that said first lateral contacts (72, 74) of each via are flush with the second face of the reconstituted substrate.

4. Method according to one of claims 1 to 3, further comprising, after step c) establishing an electrical connection between the component positioned horizontally on said reference surface (27', 127) and a metal track of a via (4).

5. Method according to one of claims 1 to 4, said component (26) positioned horizontally on said reference surface (27', 127) having a thickness less than said electronic reconstituted substrate.

6. Method according to one of claims 1 to 5, said component (26) positioned horizontally on said reference surface (27', 127) being, in a plane perpendicular thereto, and after step c), laterally surrounded by encapsulant material up to the second face (2") of the electronic reconstituted substrate.

7. Reconstituted electronic device (2) comprising:
- a first face and a second face,
- a plurality of vias (4), each via comprising a series of metal trackscomprised between 2 substrates (50, 50'), each metal track having a first lateral contact and a second lateral contact (72, 74), each via comprising a first side (3') and a second side (3") opposite to the first side, said first lateral contacts (72) projecting beyond, or being flush with, the first side, said second lateral contacts (74) projecting beyond, or being flush with, the second side, said substrates being placed perpendicular to said faces, said first lateral contacts (72) being flush with said second face of the reconstituted substrate, said second lateral contacts (74) being flush with said first face of the reconstituted substrate, each via interconnecting the first face and the second face of the reconstituted substrate,
- at least one component (26) incorporated in said reconstituted device, disposed parallel to said first and second faces and flush with one or other of the faces,
- and an encapsulant (28, 128) to fill the spaces between said at least one component (26) and the vias, and which holds them.

8. Device according to claim 7, further comprising one or more connection tracks (11, 11') on the first and/or the second face of the reconstituted electronic device.

9. Device according to one of claims 7 or 8, an electrical connection being established between a metal track (3) and the component (26).

10. Device according to one of claims 7 to 9, said component (26) having a thickness less than the distance between the first face and the second face that defines the thickness of the reconstituted electronic device.

11. Device according to one of claims 7 to 10, said component (26) incorporated in said reconstituted device, disposed parallel to said first and second faces and being flush with one of these two faces, being, in a plane perpendicular thereto, laterally surrounded by encapsulant material and covered by said encapsulant material up to the other face of the electronic reconstituted substrate.
